# EUROPEAN PATENT APPLICATION

(11) **EP 4 529 396 A2**
(43) Date of publication of application: **26.03.2025**
(21) Application number: 24200506.4
(22) Date of filing: 16.09.2024
(51) Int. Cl.: H10K 59/122, H10K 59/80

(54) **DISPLAY DEVICE**

(30) Priority: 22.09.2023 KR 20230127003
(71) Applicant: LG Display Co., Ltd., Seoul 07336 (KR)
(72) Inventor: LIM, JungBum, 10845 Paju-si, Gyeonggi-do (KR); LEE, Younghee, 10845 Paju-si, Gyeonggi-do (KR); PARK, SunIk, 10845 Paju-si, Gyeonggi-do (KR); PARK, Hyoungbin, 10845 Paju-si, Gyeonggi-do (KR)
(74) Representative: Viering, Jentschura & Partner mbB Patent- und Rechtsanwälte

(57) **Abstract**

The present disclosure provides a display device (100) including a substrate (110) on which a plurality of subpixels (SP) each including a light-emitting area (EA) and a non-light-emitting area (NEA) is defined, an overcoating layer (130) disposed on the substrate (110) and having a plurality of micro-lenses including concave portions (131) and connection portions (132) in the light-emitting area (EA), a first electrode (141) disposed on the overcoating layer (130), a bank layer (BNK) exposing a part of the first electrode (141) on the overcoating layer (130) and defining the light-emitting area (EA), a light-emitting layer (142) covering the first electrode (141) exposed by the bank layer (BNK), and a second electrode (143) disposed on the light-emitting layer (142), in which the bank layer (BNK) includes a first bank area (BNK1) disposed adjacent to at least a part of the light-emitting area (EA) and having a first thickness (d1), and a second bank area (BNK2) having a second thickness (d2) larger than the first thickness (d1).

## Description

### BACKGROUND

### Field

The present disclosure relates to a display device, and more particularly, to a display device in which a thickness of a bank layer may vary depending on a position, thereby suppressing the occurrence of a deviation of visual field brightness and stains and improving a charging rate at a low gradation.

### Description of the Related Art

Display devices, which visually display electrical information signals, are being rapidly developed in accordance with the entry into the information era. Various studies are being continuously conducted to develop a variety of display devices which are thin and lightweight, consume low power, and have improved performance.

As the representative display devices, there may be a liquid crystal display (LCD) device, a field emission display (FED) device, an electrowetting display (EWD) device, an organic light-emitting display (OLED) device, and the like.

An electroluminescent display device, as the representative organic light-emitting display device, refers to a display device that autonomously emits light. Unlike a liquid crystal display device, the electroluminescent display device does not require a separate light source and thus may be manufactured as a lightweight, thin display device. In addition, the electroluminescent display device is advantageous in terms of power consumption because the electroluminescent display device operates at a low voltage. Further, the electroluminescent display device is expected to be adopted in various fields because the electroluminescent display device is also excellent in implementation of colors, response speeds, viewing angles, and contrast ratios (CRs).

### SUMMARY

An object to be achieved by the present disclosure is to provide a display device capable of suppressing the occurrence of a deviation of visual field brightness and stains and improving a charging rate at a low gradation.

Another obj ect to be achieved by the present disclosure is to provide a display device with an improved aperture ratio.

Still another object to be achieved by the present disclosure is to provide a display device with reliability improved by suppressing moisture penetration into an outer periphery of the device.

Objects of the present disclosure are not limited to the above-mentioned obj ects, and other objects, which are not mentioned above, can be clearly understood by those skilled in the art from the following descriptions. According to an aspect of the present disclosure, a display device according to claim 1 is provided. Further embodiments are described in the dependent claims.

In one aspect of the present disclosure, there is provided a display device including: a substrate on which a plurality of subpixels each including a light-emitting area and a non-light-emitting area is defined; an overcoating layer disposed on the substrate and having a plurality of micro-lenses including concave portions and connection portions in the light-emitting area; a first electrode disposed on the overcoating layer; a bank layer exposing a part of the first electrode on the overcoating layer and defining the light-emitting area; a light-emitting layer covering the first electrode exposed by the bank layer; and a second electrode disposed on the light-emitting layer, in which the bank layer includes: a first bank area disposed adjacent to at least a part of the light-emitting area and having a first thickness; and a second bank area having a second thickness larger than the first thickness. Therefore, different thicknesses are applied to the bank layers in the first and second bank areas, which may suppress the occurrence of a deviation of visual field brightness and stains and improve the charging rate at a low gradation.

Other detailed matters of the exemplary embodiments are included in the detailed description and the drawings.

According to the present disclosure, the thickness of the bank layer at the position adjacent to at least a part of the light-emitting area in the display panel is smaller than the thickness of the bank layer positioned in the area other than the area adjacent to the light-emitting area. Therefore, it is possible to suppress the occurrence of a difference in viewing between the visual fields, minimize the occurrence of a deviation of visual field brightness and stains, and improve the charging rate at a low gradation.

In addition, according to the present disclosure, different thicknesses are applied, for each subpixel, to the bank layer on the repair part disposed between the light-emitting area and the non-light-emitting area, which may minimize an effect on the normal subpixel adjacent to a defective subpixel during the repair process, maximize the aperture ratio, and improve the afterimage performance.

In addition, according to the present disclosure, the trench pattern is formed in the non-display area of the display panel, which may suppress moisture penetration into the display panel.

The effects according to the present disclosure are not limited to the contents exemplified above, and more various effects are included in the present specification.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a block diagram of a display device according to an embodiment of the present disclosure;
FIG. 2 is a circuit diagram of a pixel of the display device according to the embodiment of the present disclosure;
FIG. 3 is a schematic top plan view of the pixel in FIG. 2;
FIG. 4 is a schematic cross-sectional view of a light-emitting area of one subpixel;
FIG. 5 is a cross-sectional view taken along line V-V' in FIG. 3;
FIG. 6 is a cross-sectional view taken along line VI-VI' in FIG. 3;
FIG. 7 is a cross-sectional view taken along line VII-VII' in FIG. 3;
FIG. 8 is a cross-sectional view taken along line VIII-VIII' in FIG. 3; and
FIG. 9 is a cross-sectional view taken along line IX-IX' in FIG. 1.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, various exemplary embodiments of the present disclosure will be described in detail with reference to the accompanying drawings.

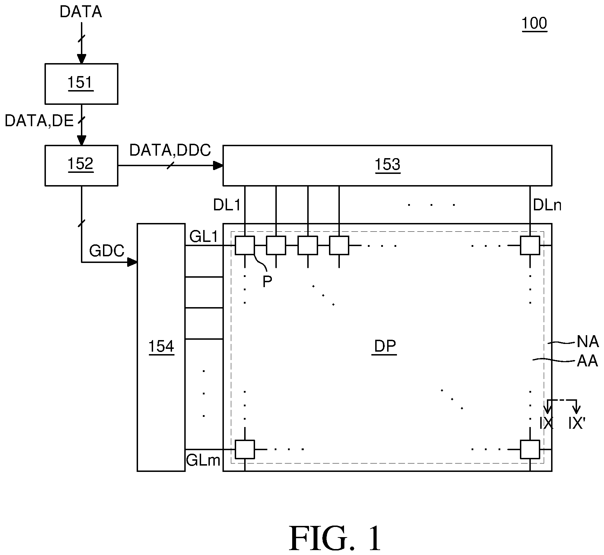

FIG. 1 is a block diagram of a display device according to an embodiment of the present disclosure.

With reference to FIG. 1, a display device 100 of an embodiment of the present disclosure may include an image processing part 151, a timing controller 152, a data drive part 153, a gate drive part 154, and a display panel DP.

In this case, the image processing part 151 may output a data signal DATA, a data enable signal DE, and the like supplied from the outside. The image processing part 151 may output one or more of a vertical synchronizing signal, a horizontal synchronizing signal, and a clock signal in addition to the data enable signal DE.

The timing controller 152 receives the data signal DATA in addition to the data enable signal DE or the driving signals including the vertical synchronizing signal, the horizontal synchronizing signal, and the clock signal from the image processing part 151. On the basis of the driving signal, the timing controller 152 may output a gate timing control signal GDC for controlling an operation timing of the gate drive part 154 and output a data timing control signal DDC for controlling an operation timing of the data drive part 153.

In addition, in response to the data timing control signal DDC supplied from the timing controller 152, the data drive part 153 may sample and latch the data signal DATA supplied from the timing controller 152, convert the data signal DATA into a gamma reference voltage, and output the gamma reference voltage. The data drive part 153 may output the data signal DATA through data lines DL1 to DLn.

In addition, the gate drive part 154 may output the gate signal while shifting a level of the gate voltage in response to the gate timing control signal GDC supplied from the timing controller 152. The gate drive part 154 may output the gate signal through gate lines GL1 to GLm.

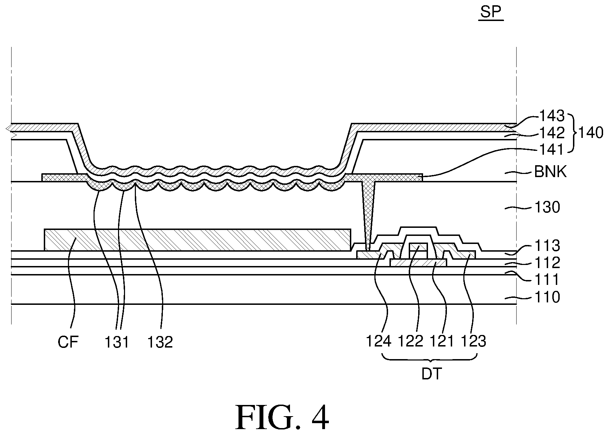

The display panel DP may display an image as a pixel P emits light in response to the data signal DATA and the gate signal supplied from the data drive part 153 and the gate drive part 154. A detailed structure of the pixel P will be described in detail with reference to FIG. 4.

The display panel DP may include a display area AA and a non-display area NA.

The display area AAis an area of the display panel DP in which images are displayed.

A plurality of pixels P and a circuit for operating the plurality of pixels P may be disposed in the display area AA. The plurality of pixels P is a minimum unit that constitutes the display area AA. The display element may be disposed in each of the plurality of pixels P. For example, an organic light-emitting element including an anode, a light-emitting layer, and a cathode may be disposed in each of the plurality of pixels P. However, the present disclosure is not limited thereto. In addition, the circuit for operating the plurality of pixels P may include driving elements, lines, and the like. For example, the circuit may include a thin-film transistor, a storage capacitor, a gate line, a data line, and the like. However, the present disclosure is not limited thereto.

The non-display area NA is an area in which no image is displayed.

The non-display area NA may be bent, such that the non-display area NDA is not visible from a front surface. The non-display area NDA may be covered by a casing (not illustrated). The non-display area NDA is called a bezel area.

FIG. 1 illustrates that the non-display area NA surrounds the display area AA having a quadrangular shape. However, the shapes and arrangements of the display area AA and the non-display area NA are not limited to the example illustrated in FIG. 1. That is, the display area AA and the non-display area NA may be suitable for the design of an electronic device equipped with the flexible display device 100. For example, an exemplary shape of the display area AA may also be a pentagonal shape, a hexagonal shape, a circular shape, an elliptical shape, or the like.

Various lines and circuits for operating the organic light-emitting element in the display area AA may be disposed in the non-display area NA. For example, the non-display area NA may include link lines for transmitting signals to the plurality of subpixels and the circuit in the display area AA. The non-display area NDA may include gate-in-panel (GIP) lines or drive ICs such as the gate drive part 154 and the data drive part 153. However, the present disclosure is not limited thereto.

The display device 100 may further include various additional elements configured to generate various signals or operate the pixel in the display area AA. The additional elements for operating the pixel may include an inverter circuit, a multiplexer, an electrostatic discharge (ESD) circuit, and the like. The display device 100 may also include additional elements related to functions other than the function of operating the pixel. For example, the display device 100 may further include additional elements that provide a touch detection function, a user certification function (e.g., fingerprint recognition), a multi-level pressure detection function, a tactile feedback function, and the like. The above-mentioned additional elements may be positioned in the non-display area NA and/or an external circuit connected to a connection interface.

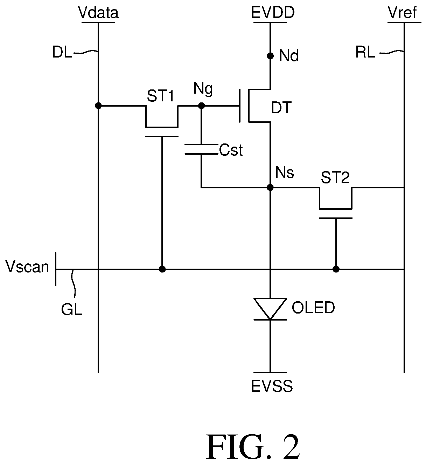

Hereinafter, a circuit of the pixel P of the display device 100 will be described in more detail with reference to FIG. 2.

FIG. 2 is a circuit diagram of the pixel of the display device according to the embodiment of the present disclosure.

With reference to FIG. 2, a pixel circuit is connected to a data line DL to which a data voltage Vdata is supplied, a reference voltage line RL to which a reference voltage Vref is supplied, and a gate line GL to which a scan signal Vscan is supplied. The scan signal Vscan is a signal that swings between a gate high voltage VGH and a gate low voltage VGL.

The pixel P includes a light-emitting element OLED, a driving element DT, a first switching element ST1, a second switching element ST2, and a storage capacitor Cst. The driving element DT and the switching elements ST1 and ST2 may each be implemented as a transistor.

The light-emitting element OLED may be implemented as an OLED including an organic compound layer formed between the anode and the cathode. The organic compound layer may include a hole injection layer HIL, a hole transport layer HTL, a light-emitting layer EML, an electron transport layer ETL, an electron injection layer EIL, and the like. However, the present disclosure is not limited thereto. The light-emitting element OLED is a light-emitting element connected between a low-potential driving power source EVSS and a third node Ns, which is connected to a source electrode of the driving element DT, and configured to emit light in accordance with a drive current. The light-emitting element OLED may be configured to display a red, green, blue, or white color.

The driving element DT includes a gate electrode connected to a first node Ng, a drain electrode connected to a second node Nd, and the source electrode connected to the third node Ns. A driving element DT operates the light-emitting element OLED by adjusting the amount of electric current to be applied to the light-emitting element OLED in response to a gate-source voltage Vgs. A pixel drive voltage VDD may be applied to the drain electrode of the driving element DT.

The first switching element ST1 includes a gate electrode connected to the gate line GL, a drain electrode connected to the data line DL, and a source electrode connected to the first node Ng. The first switching element ST1 is turned on in response to the scan signal Vscan from the gate line GL. When the first switching element ST1 is turned on, the data line DL, to which the data voltage Vdata is applied, is electrically connected to the first node Ng, such that the data voltage Vdata is applied to the gate electrode and the storage capacitor Cst of the driving element DT.

The second switching element ST2 includes a gate electrode connected to the gate line GL, a drain electrode connected to the reference voltage line RL, and a source electrode connected to the third node Ns. The second switching element ST2 is turned on in response to the scan signal Vscan from the gate line GL and electrically connects the reference voltage line RL and the third node Ns, such that the reference voltage Vref is applied to the third node Ns. The reference voltage Vref is set to a voltage lower than a pixel drive voltage EVDD. Meanwhile, the second switching element ST2 may be turned on when the electrical properties of the driving element DT need to be sensed. In this case, a sensing signal may be applied from a gate driver 13 to the gate electrode of the second switching element ST2. Because the sensing signal may be generated independently of the scan signal Vscan, an on/off timing for the second switching element ST2 may be controlled at a desired sensing time.

The storage capacitor Cst is connected between the first node Ng and the third node Ns and maintains the gate-source voltage Vgs of the driving element DT for a light emission period. As the gate-source voltage Vgs increases, the drive current increases, and the amount of light emission of the pixel P increases. In other words, the brightness of the pixel P increases in proportion to a magnitude of the voltage, i.e., the data voltage Vdata to be applied to the first node Ng.

The adjacent pixel circuits may be configured to be connected to at least one reference voltage line RL. For example, although not illustrated in FIG. 2, four pixel circuits may be configured to share one reference voltage line RL. According to the above-mentioned configuration, the number of reference voltage lines RL may be reduced, and an aperture ratio may be increased. That is, because the number of reference voltage lines RL is reduced, more subpixels may be disposed. Therefore, there is an advantage in increasing the resolution. However, the present disclosure is not limited thereto. The number of reference voltage lines RL, the number of shared pixels P, and the type of shared pixel P may be variously modified.

The subpixel illustrated in FIG. 2 has a 3T (transistor) 1C (capacitor) structure including the first switching element ST1, the second switching element ST2, the driving element DT, the capacitor Cst, and the light-emitting element OLED. However, the subpixel may have various configurations such as 4T2C, 5T2C, 6T1C, 6T2C, 7T1C, 7T2C, or the like.

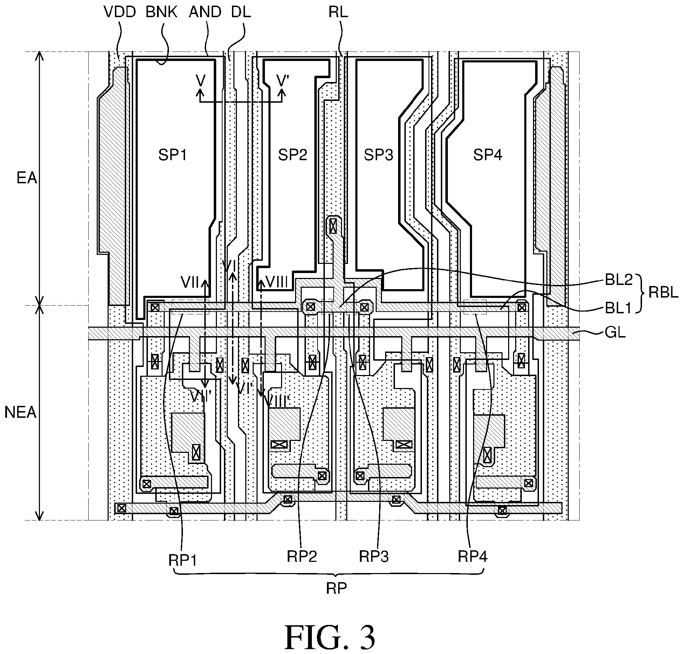

Hereinafter, the pixel P of the display device 100 will be described in more detail with reference to FIG. 3.

FIG. 3 is a schematic top plan view of the pixel in FIG. 2.

With reference to FIG. 3, the pixel P includes subpixels SP each having a light-emitting area EA and a non-light-emitting area NEA. The subpixels SP may be basic light-emitting units that constitute the display device 100. The subpixels SP, which constitute one pixel P, may emit light beams with different colors.

The subpixels SP are arranged in a first direction (e.g., an x-axis direction). For example, a first subpixel SP1 may be a red subpixel, a second subpixel SP2 may be a green subpixel, a third subpixel SP3 may be a white subpixel, and a fourth subpixel SP4 may be a blue subpixel. However, the present disclosure is not limited thereto. For example, because the green subpixel SP2 and the white subpixel SP3 have relatively high contribution to luminous efficiency and brightness, the green subpixel SP2 and the white subpixel SP3 may have smaller sizes than the red subpixel SP1 and the blue subpixel SP4.

The light-emitting area EA may include the light-emitting element OLED. The non-light-emitting area NEA may include the driving element DT, the first switching element ST1, the second switching element ST2, and the storage capacitor Cst that operate the light-emitting element OLED. The non-light-emitting area NEA may also be called a circuit part.

For example, the light-emitting area EA and the non-light-emitting area NEA are arranged in a second direction (y-axis direction) perpendicular to the first direction (the x-axis direction). The light-emitting element OLED may emit light by being operated by the pixel circuit provided in the non-light-emitting area NEA in each of the subpixels SP.

In each of the subpixels SP, the light-emitting area EA may be defined by a bank formed on an anode electrode of the light-emitting element OLED configured to expose a part of the anode electrode. That is, the anode electrode, which is exposed by the bank, may be defined as the light-emitting area EA of each of the subpixels SP.

The non-light-emitting area NEA may include lines configured to apply driving signals to the subpixels SP. The lines may include lines extending in the first direction (the x-axis direction), and lines extending in the second direction (the y-axis direction). The pixels P may share the lines with one another.

The lines extending in the first direction (the x-axis direction) may include the gate line GL. The lines extending in the first direction may intersect the lines extending in the second direction.

The lines extending in the second direction (the y-axis direction) may include the power line VDD, the reference voltage line RL, and the data line DL. The lines extending in the second direction may extend in the second direction while traversing between the subpixels SP adjacent to one another in the first direction (the x-axis direction).

The lines, which are connected to the pixels P, and the electrodes, which constitute the transistors, may be disposed on the same layer or disposed on different layers with one or more insulation layers interposed therebetween. The lines and the electrodes may be electrically connected to one another through contact holes formed through the insulation layers for electrical connection.

The data lines DL may be connected to the first switching element ST1 in the corresponding subpixel SP. The gate lines GL may be connected to the first switching element ST1 or the second switching element ST2 in each of the subpixels SP.

The drive voltage is applied in common to the pixel circuits in the subpixels SP through the power lines VDD. The power line VDD may be connected to the driving element DT in each of the subpixels SP.

The reference voltage Vref, which is applied to the reference voltage line RL, is applied to one or more subpixels SP through branch lines RBL. The branch line RBL may be connected to the second switching element ST2 in each of the subpixels SP. The branch line RBL is disposed on the circuit part. The branch line RBL extends in the first direction and transmits a signal from the reference voltage line RL, which extends in the second direction, to the subpixels SP arranged in the first direction. More specifically, a first branch line BL1 connects the reference voltage line RL and the two subpixels SP1 and SP4 disposed at two opposite ends, and a second branch line BL2 connects the reference voltage line RL and the two subpixels SP2 and SP3 disposed at a center. The branch line RBL and the reference voltage line RL may be disposed on different layers, and the branch line RBL may be electrically connected to the reference voltage line RL through a contact hole. Because the first branch line BL1 is connected to the first subpixel SP1 and the fourth subpixel SP4 spaced apart from each other with the two subpixels SP2 and SP3 interposed therebetween, the first branch line BL1 may be longer than the second branch line BL2. A central portion of the first branch line BL1 may be concavely curved so as not to interfere with the second branch line BL2. The second branch line BL2 is disposed below the concave central portion of the first branch line BL1 and connected to the adjacent second and third subpixels SP2 and SP3.

The branch line RBL is disposed on the same layer as the drain electrode of the second switching element ST2. The branch line RBL is electrically connected to an active layer of the second switching element ST2 through a second switching contact hole.

In each of the subpixels SP, the anode electrode of the light-emitting element OLED disposed in the light-emitting area EA extends in the second direction and is electrically connected to the corresponding driving element DT and the corresponding storage capacitor Cst in the non-light-emitting area NEA.

Hereinafter, a cross-sectional structure of the light-emitting area EA of one subpixel of the display device will be described with reference to FIG. 4.

FIG. 4 is a schematic cross-sectional view of the light-emitting area of one subpixel.

With reference to FIG. 4, the organic light-emitting display device 100 according to the embodiment of the present disclosure includes a substrate 110, a buffer layer 111, a gate insulation layer 112, the driving element DT, a passivation layer 113, an overcoating layer 130, the organic light-emitting element OLED, and a bank layer BNK. For convenience of description, FIG. 4 illustrates only a cross-sectional view of one subpixel of the organic light-emitting display device 100.

With reference to FIG. 4, the display device 100 according to the embodiment of the present disclosure may include the subpixel SP having a color-filter-on transistor (COT) structure. For example, a color of each of the subpixels SP may be implemented by a color filter layer CF disposed on an upper layer of the driving element DT so as to overlap the light-emitting area EA of the subpixel SP. For example, the color filter layer CF may include a red color filter, a green color filter, and a blue color filter separated to correspond to the red subpixel SP1, the green subpixel SP2, and the blue subpixel SP4 and positioned on the same plane. For example, in case that a light-emitting element 140 emits white light, a red color filter CF (R) may be disposed in an area corresponding to the light-emitting area of the light-emitting element 140, such that the red subpixel SP may be implemented. Further, a green color filter CF (G) may be disposed in an area corresponding to the light-emitting area of the light-emitting element 140, such that the green subpixel SP may be implemented. Further, a blue color filter CF (B) may be disposed in an area corresponding to the light-emitting area of the light-emitting element 140, such that the blue subpixel SP may be implemented. Further, the color filter layer CF is not disposed in an area corresponding to the light-emitting area of the light-emitting element 140, such that the white subpixel SP may be implemented. A specific description of the color filter layer CF will be described below.

The substrate 110 supports various constituent elements of the organic light-emitting display device 100. The substrate 110 may be made of an insulating material. For example, the substrate 110 may be made of glass or a plastic material such as polyimide (PI).

Although not illustrated in FIG. 4, a metal layer may be further disposed on the substrate 110 and provided in an area that overlaps a channel area of the driving element DT. The metal layer may serve as a light shield and be referred to as a light-blocking layer LS. For example, the light-blocking layer may be disposed not only below the channel area of the driving element DT but also below channel areas of the first and second switching elements ST1 and ST2.

The buffer layer 111 is disposed on the substrate 110. The buffer layer 111 is a layer for protecting the driving element DT from impurities, such as alkaline ions, leaking from the substrate 110 or layers disposed below the substrate 110. The buffer layer 111 may be made of silicon oxide (SiOx) or silicon nitride (SiNx) or configured as a multilayer including silicon oxide (SiOx) or silicon nitride (SiNx).

The driving element DT is disposed on the buffer layer 111.

The driving element DT includes an active layer 121, a gate electrode 122, a source electrode 123, and a drain electrode 124. For example, the active layer 121 may be formed on the substrate 110, the gate insulation layer 112 for insulating the gate electrode 122 and the active layer 121 is formed on the active layer 121 and the lower substrate 110, the gate electrode 122 is formed on the gate insulation layer 112, and the source electrode 123 and the drain electrode 124 are formed on the active layer 121 and the gate insulation layer 112. The source electrode 123 and the drain electrode 124 may be electrically connected to the active layer 121 while adjoining the active layer 121 and formed on a partial area of the gate insulation layer 112. In the present disclosure, for convenience of description, only the driving element is illustrated among various thin-film transistors that may be included in the light-emitting display device 100. However, a switching element may also be included. In addition, in the present disclosure, the driving element DT is described as having a coplanar structure. However, a thin-film transistor with an inverted staggered structure may also be used.

More specifically, the active layer 121 is disposed on the buffer layer 111. The active layer 121 may be made of amorphous silicon (a-Si), polycrystalline silicon (poly-Si), an oxide semiconductor, an organic semiconductor, or the like. In case that the active layer 121 is made of an oxide semiconductor, the active layer 121 may be made of indium-gallium-zinc oxide (IGZO) or the like. However, the present disclosure is not limited thereto.

The gate insulation layer 112 is disposed on the active layer 121. The gate insulation layer 112 insulates the active layer 121 and the gate electrode 122. The gate insulation layer 112 may be configured as a single layer made of silicon nitride (SiNx) or silicon oxide (SiOx) that is an inorganic material. Alternatively, the gate insulation layer 112 may be configured as a multilayer made of silicon nitride (SiNx) or silicon oxide (SiOx). However, the present disclosure is not limited thereto.

The gate electrode 122 is disposed on the gate insulation layer 112. The gate electrode 122 may be made of a conductive metal, for example, titanium (Ti), copper (Cu), aluminum (Al), molybdenum (Mo), or an alloy thereof. However, the present disclosure is not limited thereto.

The source electrode 123 and the drain electrode 124 are disposed on the gate insulation layer 112. The source electrode 123 and the drain electrode 124 may be electrically connected to the active layer 121 through a contact hole formed in the gate insulation layer 112. The source electrode 123 and the drain electrode 124 may each be made of various electrically conductive materials, for example, magnesium (Mg), aluminum (Al), nickel (Ni), chromium (Cr), molybdenum (Mo), tungsten (W), gold (Au), or an alloy thereof. However, the present disclosure is not limited thereto.

The passivation layer 113 may be conformally disposed on the driving element DT. For example, the passivation layer 113 may be formed in accordance with a shape of a top surface of the driving element DT. Further, the passivation layer 113 may be formed to cover the driving element DT, and the passivation layer 113 may be disposed on a front surface of the substrate 110 on which the driving element DT is disposed.

The passivation layer 113 may be disposed to cover the driving element DT. The passivation layer 113 may protect the driving element DT from oxygen or moisture from the outside of the light-emitting display device 100. Various organic or inorganic films may be used as the passivation layer 113, and the passivation layer 113 may have various structures such as an organic film-only deposition structure, an inorganic film-only deposition structure, or an organic/inorganic film alternating deposition structure. For example, the passivation layer 113 may be made of silicon nitride (SiNx), silicon oxide (SiOx), or the like. However, the present disclosure is not limited thereto.

The color filter layer CF may be disposed on the passivation layer 113 so as to overlap the light-emitting area EA of the subpixel SP. In this case, the light-emitting area EA means an area in which a light-emitting layer 142 emits light by means of a first electrode 141 and a second electrode 143. For example, the color filter layer CF is formed to overlap the light-emitting area EA. However, a forming position and size of the color filter layer CF may be determined by not only a size and position of the light-emitting area but also various factors such as a distance between the color filter layer CF and the first electrode 141, a distance between the color filter layer CF and the concave portion of the overcoating layer 130, and a distance between the light-emitting areas.

The overcoating layer 130 is disposed on the color filter layer CF and the passivation layer 113. For example, the overcoating layer 130 may be made of any one of acrylic resin, epoxy resin, phenolic resin, polyamide-based resin, polyimide-based resin, unsaturated polyester-based resin, polyphenylene-based resin, polyphenylene sulfide-based resin, benzocyclobutene, and photoresist. However, the present disclosure is not limited thereto.

The overcoating layer 130 has a plurality of micro-lenses including a plurality of concave portions 131 formed to overlap the color filter layer CF, and connection portions 132 configured to connect the plurality of concave portions 131. The plurality of concave portions 131 may each have a hemispherical or semi-ellipsoidal shape. The overcoating layer 130 provides a planarized top surface on a portion where the plurality of concave portions 131 is not formed. The plurality of micro-lenses may extract light, which is trapped in the light-emitting element 140, to the outside, thereby improving the efficiency of the display device 100. More specifically, the light, which is emitted from the light-emitting layer 142 to be described below, may be totally reflected by the first electrode 141, i.e., an interface between the anode and the overcoating layer 130. However, because the overcoating layer 130 of the display device 100 according to the embodiment of the present disclosure includes the plurality of concave portions 131 and the connection portions 132, the overcoating layer 130 may define a micro-lens array structure. Therefore, it is highly unlikely that an incident angle of the light, which is emitted from the light-emitting layer 142 and enters the interface of the overcoating layer 130, is smaller than a total reflection threshold angle, which may reduce the amount of light trapped in the display device 100.

In case that the micro-lens including the plurality of concave portions 131 is formed on the overcoating layer 130 by a process such as photolithography, the connection portions 132, i.e., peaky portions where morphology is rapidly changed between the plurality of concave portions 131, are present on the overcoating layer 130, as illustrated in FIG. 4. However, the plurality of light-emitting layers 142 of the organic light-emitting element ED is formed in a way, such as thermal evaporation, which degrades step coverage of the plurality of light-emitting layers 142. Further, the plurality of light-emitting layers 142 is formed with a very small thickness of several hundreds of nanometers. There may occur an area in which no organic light-emitting layer is formed on the first electrode 141, and there is a high probability that the first electrode 141 and the second electrode 143 are short-circuited. Therefore, although not illustrated in FIG. 4, an insulation layer may be additionally disposed between the first electrode 141 and the overcoating layer 130 to mitigate a level difference that may be caused by the plurality of concave portions 131.

The light-emitting element 140 is disposed on the overcoating layer 130. The light-emitting element 140 includes the anode 141, the light-emitting layer 142, and the cathode 143.

The anode 141 is formed on the overcoating layer 130 while corresponding to the light-emitting area of each of the pixels P. The anode 141 may be electrically connected to the drain electrode 124 of the driving element DT through a contact hole of the overcoating layer 130. The anode 141 may be made of a metallic material.

The bank layer BNK is disposed on the anode 141 and the overcoating layer 130. The bank layer BNK may cover an end of the anode 141 and define the light-emitting area EA. Therefore, the bank layer BNK may expose the anode 141 corresponding to the light-emitting area. The bank layer BNK may be disposed at a boundary between the adjacent subpixels SP and reduce a color mixture of the light beams emitted from the light-emitting elements 140 of the plurality of subpixels SP.

The bank layer BNK may be made of a black material. The bank layer BNK may include a black material and serve to cover the metal layers that may be visually recognized through the display area AA. For example, the bank layer BNK may be made of a carbon-based mixture. For example, the bank layer BNK may include carbon black. However, the present disclosure is not limited thereto.

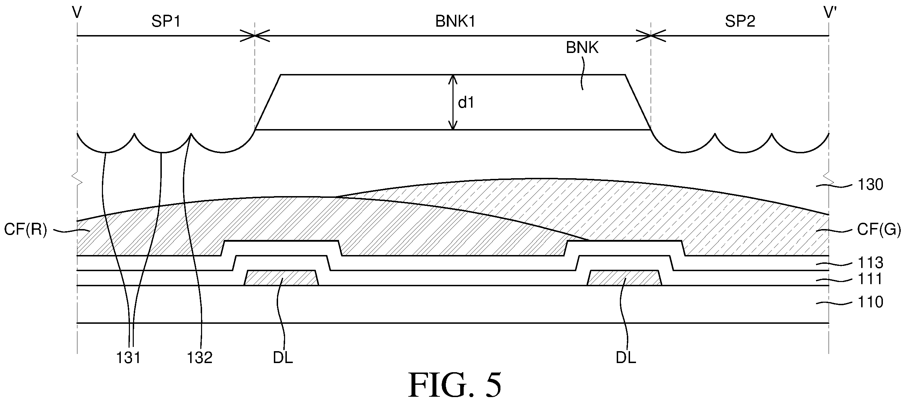

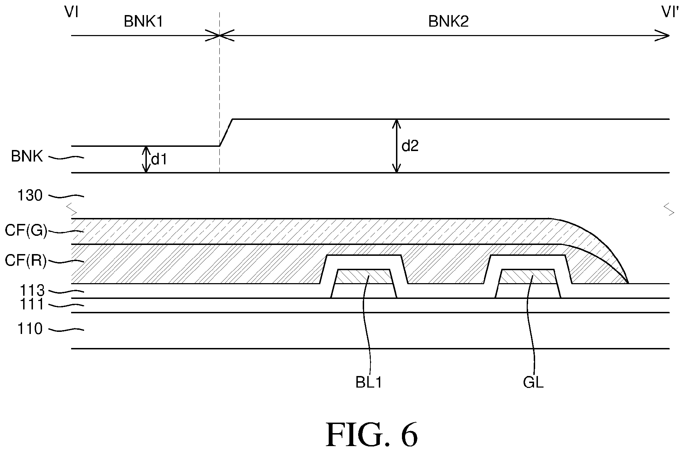

The bank layer BNK will be described in more detail with reference to FIGS. 5 and 6.

A spacer may be further formed on the bank layer BNK. The spacer may be made of the same material as the bank layer BNK. The spacer may serve to suppress damage to the light-emitting element 140 that may be caused by a fine metal mask (FMM) used to pattern the organic light-emitting layer 142.

The light-emitting layer 142 is disposed on the anode 141 exposed by the bank layer BNK. The light-emitting layer 142 may include a hole injection layer, a hole transport layer, a light-emitting layer, an electron transport layer, an electron injection layer, and the like.

The second electrode 143, i.e., the cathode is disposed on the light-emitting layer 142. Because the cathode 143 supplies electrons to the light-emitting layer 142, the cathode 143 may be made of an electrically conductive material having a low work function. The cathode 143 may be configured as a single layer over the plurality of subpixels SP. That is, the cathodes 143 of the plurality of subpixels SP may be connected to and integrated with one another.

Hereinafter, a cross-sectional structure of the bank layer disposed between the light-emitting areas EA of the display device will be described with reference to FIGS. 5 and 6.

FIG. 5 is a cross-sectional view taken along line V-V' in FIG. 3. FIG. 6 is a cross-sectional view taken along line VI-VI' in FIG. 3. The display device 100 illustrated in FIGS. 5 and 6 is substantially identical in configuration to the display device 100 in FIG. 4, except for the bank layer. Therefore, for convenience of description, a repeated description of the components of the display device 100, except for the bank layer BNK, will be omitted.

According to the embodiment of the present disclosure, the bank layer BNK may include a first bank area BNK1 adjacent to at least a part of the light-emitting area EA, and a second bank area BNK2 different in thickness from the first bank area BNK1.

In the related art, when the plurality of micro-lenses is applied to improve the efficiency of the display device by extracting the light, which is trapped in the light-emitting element, to the outside, the bank layer flows into the plurality of micro-lenses on the overcoating layer during the process of performing the heat treatment on the bank layer, which causes a problem in that residual films are formed in concave portions of outermost peripheries of the plurality of micro-lenses. In this case, there is a problem in that a deviation of visual field brightness and stains are caused by a difference in viewing between left and right visual fields because of the residual films in the concave portions of the outermost peripheries of the plurality of micro-lenses. Therefore, in case that the thickness of the bank layer is decreased to inhibit the bank layer from flowing into the plurality of micro-lenses and forming the residual films, there is a problem in that a charging rate at a low gradation decreases, and an aperture ratio decreases.

Therefore, according to the embodiment of the present disclosure, the above-mentioned problems are suppressed by applying different thicknesses to the bank layer BNK in accordance with the positions.

According to the embodiment of the present disclosure, the bank layer BNK adjacent to at least a part of the light-emitting area EA defines the first bank area BNK1 having a first thickness d1. The first bank area BNK1 may be disposed between the light-emitting areas EA of two subpixels SP adjacent to each other in the first direction (the x-axis direction) (for example, the first bank area BNK1 may be disposed between the light-emitting areas EA of each two subpixels SP that are adjacent to each other in the first direction). For example, the plurality of subpixels SP may be arranged in the first direction, and the light-emitting area EA has a length in the second direction (the y-axis direction), which is perpendicular to the first direction, longer than a length in the first direction (the x-axis direction). In this case, the first direction may be a direction of a viewing angle of a user. For example, the first bank area BNK1 may overlap the data line DL extending in the second direction perpendicular to the first direction.

As illustrated in FIG. 5, according to the embodiment of the present disclosure, the first bank area BNK1, which is disposed between the light-emitting areas EA of two subpixels SP adjacent to each other in the first direction, may have the first thickness d1. For example, the first thickness d1 may be 1.0 to 2.0 µm.

According to the embodiment of the present disclosure, the first bank area BNK1 has the first thickness d1, such that the first bank area BNK1 may not flow into the plurality of micro-lenses even though the heat treatment is performed after the bank layer BNK is formed. For example, in the first bank area BNK1, a side surface of the bank layer BNK may overlap the connection portions 132 of the plurality of micro-lenses without overlapping the concave portions 131 of the plurality of micro-lenses.

In addition, according to the embodiment of the present disclosure, the bank layer BNK includes the second bank area BNK2 having a second thickness d2 larger than the first thickness d1 of the first bank area BNK1.

According to the embodiment of the present disclosure, a circuit part may be further disposed between the light-emitting areas EA of two subpixels SP adjacent to each other in the second direction (the y-axis direction) perpendicular to the first direction (the x-axis direction)

(for example, the circuit part may be disposed between the light emitting areas EA of each subpixels SP that are adjacent to each other in the second direction). In this case, the circuit part may be disposed in the non-light-emitting area NEA of the subpixel SP. For example, the second bank area BNK2, which has the second thickness d2 larger than the first thickness d1 of the first bank area BNK1, may overlap the circuit part.

According to the embodiment of the present disclosure, because the second bank area BNK2 has the second thickness d2, the second bank area BNK2 may flow into the plurality of micro-lenses during the process of performing the heat treatment after the bank layer BNK is formed, which may cause a residual film. For example, in the second bank area BNK2, the side surface of the bank layer BNK may overlap some of the concave portions 131 disposed at the outer peripheries of the plurality of micro-lenses.

As illustrated in FIG. 6, the second bank area BNK2, which is relatively distant from the light-emitting area EA, has the second thickness d2 relatively larger than the first thickness d1, such that a distance between the cathode 143 and the line disposed on the circuit part may be increased, which may minimize parasitic capacitance that may occur between the line and the cathode 143. In addition, the minimization of the parasitic capacitance may improve the charging rate at a low gradation. For example, the second thickness d2 may be 2.5 to 3.5 µm.

According to the embodiment of the present disclosure, the bank layer BNK including the first and second bank areas BNK1 and BNK2 having different thicknesses may be implemented by using a halftone mask including a light-transmitting portion, a semi-transmissive portion, and a light-blocking portion. Specifically, after the bank layer BNK is formed on the overcoating layer 130, a mask is positioned on the substrate 110 including the bank layer BNK. In this case, the mask may be the halftone mask including the light-transmitting portion, the semi-transmissive portion, and the light-blocking portion. Specifically, the light-transmitting portion of the mask may be positioned to correspond to the light-emitting area EA of the subpixel SP, the semi-transmissive portion of the mask may be positioned to correspond to a portion between the light-emitting areas EA of the subpixels SP, and the light-blocking portion of the mask may be positioned to correspond to the non-light-emitting area NEA of the subpixel SP. Thereafter, after the bank layer BNK is irradiated with light by using the mask, a development process is performed. In this case, a portion of the bank layer on the overcoating layer, which is not exposed by the light-blocking portion of the mask, remains in an intact manner, a portion of the bank layer on the overcoating layer, which is exposed through the light-transmitting portion, is completely removed, and a portion of the bank layer on the overcoating layer, which is exposed through the semi-transmissive portion, is removed by a partial thickness. Thereafter, the heat treatment is performed, such that the first bank area BNK1 having the first thickness d1 is configured in an area corresponding to the semi-transmissive portion, the second bank area BNK2 having the second thickness d2 is configured in an area corresponding to the light-blocking portion, and the light-emitting area EA is configured in an area corresponding to the light-transmitting portion.

According to the embodiment of the present disclosure, the halftone mask is used to implement the configuration in which the first thickness d1 of the first bank area BNK1 adjacent to the light-emitting area EA having the plurality of micro-lenses is relatively smaller than the second thickness d2 of the second bank area BNK2 distant from the light-emitting area. Therefore, even though the heat treatment is performed, it is possible to inhibit the bank layer in the first bank area BNK1 having the first thickness d1 from flowing into the concave portions 131 disposed at the outermost peripheries of the plurality of micro-lenses and forming a residual film. Therefore, because no residual film is formed in the plurality of micro-lenses, it is possible to suppress a vertical stripe problem in which the lenses disposed at the outermost peripheries of the micro-lenses are visually recognized.

With reference to FIG. 3 together, the display device 100 according to the embodiment of the present disclosure may further include repair parts RP respectively disposed in the non-light-emitting areas NEA of the plurality of subpixels SP. For example, the repair part RP may be disposed between the light-emitting area EA and the non-light-emitting area NEA or between the light-emitting area EA and the circuit part. In this case, the bank layer BNK may further include a third bank area BNK3 disposed to overlap the repair part RP.

In the display device 100, the repair part RP means an area in which lines or electrodes of some nodes of a pixel circuit of a defective subpixel are irradiated with laser beams to block a current path to the defective subpixel when the defective subpixel on the display panel is detected. That is, the defective subpixel becomes a dark spot by blocking the current path by irradiating the repair part RP with laser beams, which may suppress an abnormal operation of the subpixel and minimize a situation in which the defective subpixel is visually recognized by the user.

Hereinafter, a case in which the repair part RP is formed on the branch line RBL will be described. That is, the current path may be blocked by irradiating the repair part RP, which is provided on the branch line RBL, with laser beams. However, the present disclosure is not limited thereto. The repair part RP may also be formed on the line or node connected to the first switching element ST1 or the second switching element ST2 in each of the subpixels SP from the gate line GL.

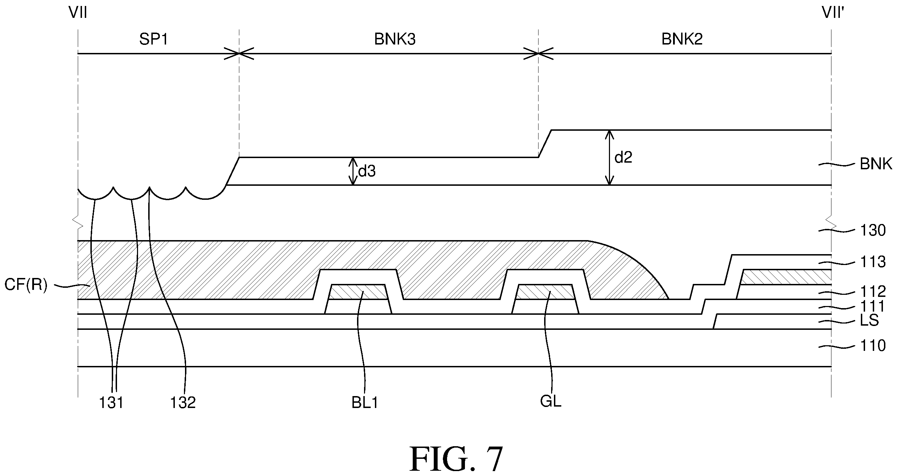

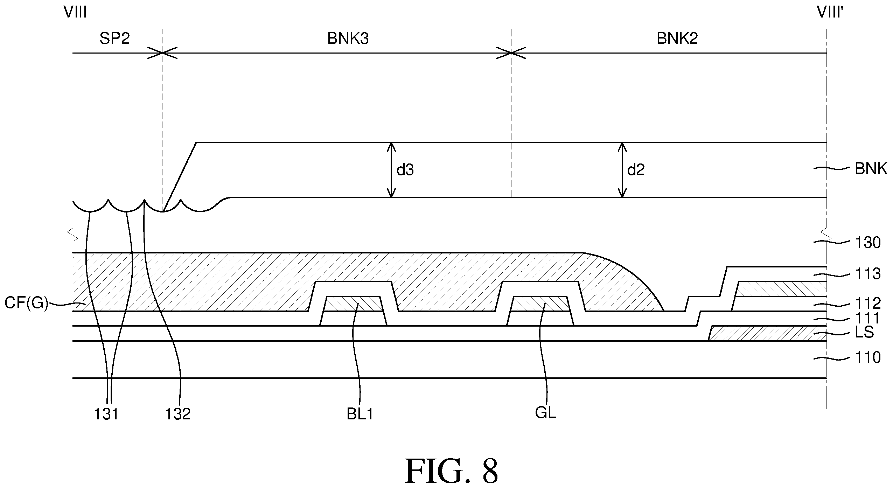

Hereinafter, the bank layer BNK in the area, which overlaps the branch line RBL for each of the subpixels SP, will be described with reference to FIGS. 7 and 8.

FIG. 7 is a cross-sectional view taken along line VII-VII' in FIG. 3. FIG. 8 is a cross-sectional view taken along line VIII-VIII' in FIG. 3. Specifically, FIG. 7 is a cross-sectional view illustrating the light-emitting area EA, the repair part RP, and the circuit part in the red subpixel SP1, and FIG. 8 is a cross-sectional view illustrating the light-emitting area EA, the repair part RP, and the circuit part in the green subpixel SP2.

With reference to FIG. 3 together, the plurality of subpixels SP according to the embodiment of the present disclosure may each further include the branch line RBL disposed between the light-emitting area EA and the non-light-emitting area NEA, e.g., between the light-emitting area EA and the circuit part. For example, the branch line RBL may be formed on the same layer and made of the same metal as the gate electrode of the second switching element ST2. In this case, the bank layer BNK may further include the third bank area BNK3 disposed to overlap the branch line RBL.

According to the embodiment of the present disclosure, a thickness d3 of the third bank area BNK3 may be equal to or smaller than the second thickness, or equal to the first thickness. For example, the thickness d3 of the third bank area BNK3 may be equal to the thickness d2 of the second bank area BNK2. Alternatively, the thickness d3 of the third bank area BNK3 may be smaller than the thickness d2 of the second bank area BNK2 and equal to the thickness d1 of the first bank area BNK2. The thickness d3 of the third bank area BNK3 may vary depending on the subpixel SP in which the third bank area BNK3 is positioned. Hereinafter, the thickness d3 of the third bank area BNK3 disposed to overlap the branch line RBL in each of the subpixels SP will be described.

According to the embodiment of the present disclosure, the plurality of subpixels SP may include the first subpixel SP1, the second subpixel SP2, the third subpixel SP3, and the fourth subpixel SP4. For example, the first subpixel SP1 may be a red subpixel, the second subpixel SP2 may be a green subpixel, the third subpixel SP3 may be a white subpixel, and the fourth subpixel SP4 may be a blue subpixel. However, the present disclosure is not limited thereto. In this case, the plurality of subpixels SP, which excludes the white subpixel SP3, may each include the color filter layer CF disposed to overlap the light-emitting area EA and the branch line RBL on the substrate.

According to the embodiment of the present disclosure, in case that a defective subpixel is detected during an inspection process performed after the pixel array of the display panel is completely formed, the current path to the defective subpixel may be blocked by irradiating the lines or electrodes of some nodes of the pixel circuit of the defective subpixel with laser beams. Therefore, the defective subpixel may become a dark spot, which may minimize a situation in which the defective subpixel is visually recognized by the user.

With reference to FIG. 3 together, a repair process may be performed by irradiating the metal of the branch line RBL, which supplies power to the pixel circuit, with laser beams so that the defective subpixel becomes a dark spot. For example, the repair process may be performed by irradiating first to fourth repair parts RP1, RP2, RP3, and RP4 of the branch line RBL with laser beams. For example, in case that the first subpixel SP1 is a defective subpixel, the first repair part RP 1 of the branch line RBL may be irradiated with laser beams, and a supply of power to the first subpixel SP1 may be cut off. The metal line may be disconnected by being melted by laser beams generated from a general laser device. In this case, the emitted laser beams are absorbed by the color filter layer CF (e.g., the red color filter or the blue color filter) or the bank layer BNK, such that the laser beams do not affect the normal subpixel positioned in the vicinity of the defective subpixel.

However, in case that laser beams are emitted from below the substrate in the green subpixel in which the white subpixel, in which no color filter layer is disposed, and the green color filter layer, which transmits laser beams with wavelengths (e.g., 532 nm), are disposed, the laser beams are not absorbed by the color filter layer, and the laser beams may affect the normal subpixel positioned in the vicinity of the defective subpixel.

Therefore, according to the embodiment of the present disclosure, the thickness d3 of the third bank area BNK3 in the subpixel SP, i.e., the green subpixel SP2 and the white subpixel SP3, in which laser beams are not absorbed by the color filter layer or the color filter layer is not disposed, may be larger than the thickness d3 of the third bank area BNK3 in the sub-pixel SP, i.e., the red subpixel SP1 and the blue subpixel SP4 in which laser beams are absorbed by the color filter layer. Therefore, in the subpixel SP in which laser beams are not absorbed by the color filter layer or the color filter layer is not disposed, the laser beams are absorbed by the third bank area BNK3, such that the laser beams do not affect the normal subpixel positioned in the vicinity of the defective subpixel.

For example, the thickness d3 of the third bank area BNK3 in the sub-pixel SP, i.e., the red subpixel SP1 and the blue subpixel SP4 in which laser beams are absorbed by the color filter layer may be equal to the first thickness d1. The thickness d3 of the third bank area BNK3 in the green subpixel SP2 and the white subpixel SP3 in which laser beams are not absorbed by the color filter layer or the color filter layer is not disposed may be equal to the second thickness d2.

According to the embodiment of the present disclosure, because the thickness d3 of the third bank area BNK3 in the red subpixel SP1 and the blue subpixel SP4 is equal to the first thickness d1, the third bank area BNK3 in the red subpixel SP1 and the blue subpixel SP4 may not flow into the plurality of micro-lenses even though the heat treatment is performed after the bank layer BNK is formed. For example, in the third bank area BNK3 in the red subpixel SP1 and the blue subpixel SP4, the side surface of the bank layer BNK may overlap the connection portions 132 of the plurality of micro-lenses without overlapping the concave portions 131 of the plurality of micro-lenses.

In addition, according to the embodiment of the present disclosure, because the thickness d3 of the third bank area BNK3 in the green subpixel SP2 and the white subpixel SP3 is equal to the second thickness d2, the third bank area BNK3 in the green subpixel SP2 and the white subpixel SP3 may flow into the plurality of micro-lenses and form a residual film when the heat treatment is performed after the bank layer BNK is formed. For example, in the third bank area BNK3 in the green subpixel SP2 and the white subpixel SP3, the side surface of the bank layer BNK may overlap some of the concave portions 131 disposed at the outer peripheries of the plurality of micro-lenses.

In addition, according to the embodiment of the present disclosure, because the thickness d3 of the third bank area BNK3 in the green subpixel SP2 and the white subpixel SP3 is equal to the second thickness d2, laser beams may be absorbed by the third bank area BNK3 of the green subpixel SP2 or the third bank area BNK3 of the white subpixel SP3, which is formed to be relatively thicker than the third bank area BNK3 of the red subpixel SP1 and the third bank area BNK3 of the blue subpixel SP4 even though a defective subpixel occurs in the green subpixel SP2 or the white subpixel SP3 and the laser beams are emitted to block the current path to the defective subpixel.

According to the embodiment of the present disclosure, because the thickness d3 of the third bank area BNK3 of the green subpixel SP2 or the third bank area BNK3 of the white subpixel SP3 is relatively large, the laser beams may be easily absorbed. Therefore, the color filter layer does not need to be additionally disposed in the third bank area BNK3 of the green subpixel SP2 or the third bank area BNK3 of the white subpixel SP3. Therefore, the aperture ratio of the subpixel SP may also be maximized, and afterimage performance of the display device may be improved.

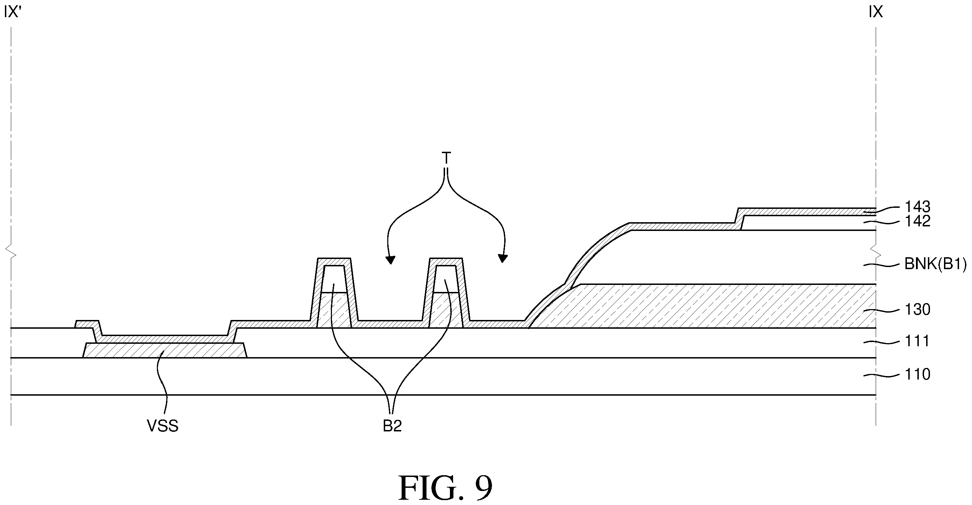

Hereinafter, the bank layer disposed in the non-display area NA of the display panel DP will be described with reference to FIG. 9.

FIG. 9 is a cross-sectional view taken along line IX-IX' in FIG. 1.

The display panel DP includes the display area AA, in which the plurality of subpixels SP is disposed, and the non-display area NA configured to surround the display area AA.

The non-display area NA may include the bank layer BNK extending from the display area AA along all the four surfaces that surround the display area AA, and at least one trench pattern T disposed to be closer to an outer periphery of the non-display area NA than the bank layer BNK extending from the display area AA. In this case, the bank layer BNK extending from the display area AA may be referred to as a first bank B 1.

The trench pattern T formed in the non-display area NA at the outer periphery of the display area AA may suppress the penetration or propagation of moisture into the display panel DP from the outer peripheral portion of the display panel DP.

In addition, the non-display area NA may further include a plurality of second banks B2 disposed to be closer to the outer periphery of the non-display area NA than at least one trench pattern T. For example, the first bank B1 may be divided by a plurality of trench patterns T disposed in the non-display area NA of the display panel DP, such that the second bank B2 may be formed.

A thickness of the second bank B2 separated from the first bank B1 by the trench pattern T is smaller than a thickness of the first bank B1, such that it is possible to inhibit the first bank B1 from overflowing into the trench pattern T and forming a residual film in the trench pattern T during the heat treatment process performed after the first bank B 1 is formed. Therefore, it is possible to suppress a deterioration in moisture penetration performance.

For example, the thickness of the first bank B1 may be 2.5 to 3.5 µm, and the thickness of the second bank B2 may be 1.0 to 2.0 µm.

The exemplary embodiments of the present disclosure can also be described as follows:

According to an aspect of the present disclosure, a display device includes a substrate on which a plurality of subpixels each comprising a light-emitting area and a non-light-emitting area is defined, an overcoating layer disposed on the substrate and having a plurality of micro-lenses comprising concave portions and connection portions in the light-emitting area, a first electrode disposed on the overcoating layer, a bank layer exposing a part of the first electrode on the overcoating layer and define the light-emitting area, a light-emitting layer covering the first electrode exposed by the bank layer, and a second electrode disposed on the light-emitting layer, the bank layer includes a first bank area disposed adjacent to at least a part of the light-emitting area and having a first thickness, and a second bank area having a second thickness larger than the first thickness.

The bank layer may be made of a black material.

The plurality of subpixels may be arranged in a first direction, and the first bank area may be disposed between the light-emitting areas of two subpixels adjacent to each other in the first direction. For example, the first bank area may be disposed between the light-emitting areas of each two subpixels that are adjacent to each other in the first direction.

The first bank area may overlap a data line extending in a second direction perpendicular to the first direction.

The light-emitting area may have a length in a second direction, which is perpendicular to the first direction, longer than a length in the first direction, and the first direction may be a direction of a viewing angle of a user.

The display device may further include a circuit part disposed between the light-emitting areas of two subpixels adjacent to each other in a second direction perpendicular to the first direction, the second bank area may overlap the circuit part. For example, the circuit part may be disposed between the light-emitting areas of each two subpixels that are adjacent to each other in the second direction.

The display device may further include a repair part disposed between the circuit part and the light-emitting area of each of the plurality of subpixels, the bank layer may further include a third bank area disposed to overlap the repair part.

A thickness of the third bank area may be equal to or smaller than the second thickness.

A thickness of the third bank area may be equal to the first thickness.

The plurality of subpixels may comprise a first subpixel, a second subpixel, a third subpixel, and a fourth subpixel, and a thickness of the third bank area in the second subpixel and the third subpixel may be larger than a thickness of the third bank area in the remaining subpixels.

The display device may further include color filter layers disposed to overlap the light-emitting area and the repair part on the substrate, the color filter layers may be separated to respectively correspond to the first subpixel, the second subpixel, and the fourth subpixel and positioned on the same plane as one another.

A thickness of the third bank area in the second subpixel and the third subpixel may be equal to the second thickness, and a thickness of the third bank area in the remaining subpixels among the plurality of subpixels may be equal to the first thickness.

The second subpixel may emit green light, and the third subpixel may emit white light.

The substrate may comprise a display area in which the plurality of subpixels is disposed, and a non-display area surrounding the display area, the non-display area may comprise a first bank extending from the display area, at least one trench pattern disposed to be closer to an outer periphery of the non-display area than the first bank, and a plurality of second banks disposed to be closer to the outer periphery of the non-display area than the trench pattern, and a thickness of the second bank may be smaller than a thickness of the first bank.

A thickness of the first bank may be 2.5 to 3.5 µm, and a thickness of the second bank may be 1.0 to 2.0 µm.

A side surface of the bank layer in the first bank area may overlap the connection portions of the plurality of micro-lenses, and a side surface of the bank layer in the second bank area may overlap some of the concave portions disposed at outer peripheries of the plurality of micro-lenses.

A side surface of the bank layer in the third bank area in the remaining subpixels among the plurality of subpixels may overlap the connection portions of the plurality of micro-lenses.

A side surface of the bank layer in the third bank area in the second subpixel and the third subpixel may overlap some of the concave portions disposed at outer peripheries of the plurality of micro-lenses.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims.

## Claims

1. A display device (100) comprising:
a substrate (110) on which a plurality of subpixels (SP) each comprising a light-emitting area (EA) and a non-light-emitting area (NEA) is defined;
an overcoating layer (130) disposed on the substrate (110) and having a plurality of micro-lenses comprising concave portions (131) and connection portions (132) in the light-emitting area (EA);
a first electrode (141) disposed on the overcoating layer (130);
a bank layer (BNK) exposing a part of the first electrode (141) on the overcoating layer (130) and defining the light-emitting area (EA);
a light-emitting layer (142) covering the first electrode (141) exposed by the bank layer (BNK); and
a second electrode (143) disposed on the light-emitting layer (142),
wherein the bank layer (BNK) comprises:
a first bank area (BNK1) disposed adjacent to at least a part of the light-emitting area (EA) and having a first thickness (d1); and
a second bank area (BNK2) having a second thickness (d2) larger than the first thickness (d1).

2. The display device (100) of claim 1, wherein the bank layer (BNK) is made of a black material.

3. The display device (100) of claim 1 or 2, wherein the plurality of subpixels (SP) is arranged in a first direction, and the first bank area (BNK1) is disposed between the light-emitting areas (EA) of two subpixels (SP) adjacent to each other in the first direction.

4. The display device (100) of claim 3, wherein the first bank area (BNK1) overlaps a data line (DL) extending in a second direction perpendicular to the first direction.

5. The display device (100) of claim 3 or 4, wherein the light-emitting area (EA) has a length in a second direction, which is perpendicular to the first direction, longer than a length in the first direction, and the first direction is a direction of a viewing angle of a user.

6. The display device (100) of any of claims 3 to 5, further comprising:
a circuit part disposed between the light-emitting areas (EA) of two subpixels (SP) adjacent to each other in a second direction perpendicular to the first direction,
wherein the second bank area (BNK2) overlaps the circuit part.

7. The display device (100) of claim 6, further comprising:
a repair part (RP) disposed between the circuit part and the light-emitting area (EA) of each of the plurality of subpixels (SP),
wherein the bank layer (BNK) further comprises a third bank area (BNK3) disposed to overlap the repair part (RP).

8. The display device (100) of claim 7, wherein a thickness (d3) of the third bank area (BNK3) is equal to or smaller than the second thickness (d2).

9. The display device (100) of claim 7 or 8, wherein a thickness (d3) of the third bank area is equal to the first thickness (d1).

10. The display device (100) of any of claims 7 to 9, wherein the plurality of subpixels (SP) comprises a first subpixel (SP1), a second subpixel (SP2), a third subpixel (SP3), and a fourth subpixel (SP4), and a thickness of the third bank area (BNK3) in the second subpixel (SP2) and the third subpixel (SP3) is larger than a thickness of the third bank area (BNK3) in the remaining subpixels (SP1, SP4).

11. The display device (100) of claim 10, further comprising:
color filter layers (CF) disposed to overlap the light-emitting area (EA) and the repair part (RP) on the substrate (110),
wherein the color filter layers (CF) are separated to respectively correspond to the first subpixel (SP1), the second subpixel (SP2), and the fourth subpixel (SP4) and positioned on the same plane as one another.

12. The display device (100) of claim 11, wherein a thickness of the third bank area (BNK3) in the second subpixel (SP2) and the third subpixel (SP3) is equal to the second thickness (d2), and a thickness of the third bank area (BNK3) in the remaining subpixels (SP1, SP4) among the plurality of subpixels (SP1, ..., SP4) is equal to the first thickness (d1),
wherein, preferably, a side surface of the bank layer (BNK) in the third bank area (BNK3) in the remaining subpixels (SP) among the plurality of subpixels (SP) overlaps the connection portions (132) of the plurality of micro-lenses.

13. The display device (100) of claim 12, wherein the second subpixel (SP2) is configured to emit green light, and the third subpixel (SP3) is configured to emit white light,
wherein, preferably, a side surface of the bank layer (BNK) in the third bank area (BNK3) in the second subpixel (SP2) and the third subpixel (SP3) overlaps some of the concave portions (131) disposed at outer peripheries of the plurality of micro-lenses.

14. The display device (100) of any of claims 1 to 13, wherein the substrate (110) comprises:
a display area (AA) in which the plurality of subpixels (SP) is disposed; and
a non-display area (NA) surrounding the display area (AA),
wherein the non-display area (NA) comprises:
a first bank (B1) extending from the display area (AA);
at least one trench pattern (T) disposed to be closer to an outer periphery of the non-display area (NA) than the first bank (B1); and
a plurality of second banks (B2) disposed to be closer to the outer periphery of the non-display area (NA) than the trench pattern (T), and
wherein a thickness of the second bank (B2) is smaller than a thickness of the first bank (B 1),
wherein, preferably, a thickness of the first bank (B1) is 2.5 to 3.5 µm, and a thickness of the second bank is 1.0 to 2.0 µm.

15. The display device (100) of any of claims 1 to 14, wherein a side surface of the bank layer (BNK) in the first bank area (BNK1) overlaps the connection portions (132) of the plurality of micro-lenses, and a side surface of the bank layer (BNK) in the second bank area (BNK2) overlaps some of the concave portions (131) disposed at outer peripheries of the plurality of micro-lenses.
